# EUROPEAN PATENT APPLICATION

(11) **EP 4 425 571 A1**
(43) Date of publication of application: **04.09.2024**
(21) Application number: 24158754.2
(22) Date of filing: 21.02.2024
(51) Int. Cl.: H01L 31/0224, H01L 31/048, H01L 31/0747

(54) **SOLAR CELL MODULE AND SOLAR CELL ARRAY**

(30) Priority: 28.02.2023 JP 2023029536
(71) Applicant: Panasonic Holdings Corporation, Osaka 571-8501 (JP)
(72) Inventor: IRIKAWA, Junpei, Kadoma-shi, Osaka, 571-0057 (JP)
(74) Representative: Müller-Boré & Partner Patentanwälte PartG mbB

(57) **Abstract**

A solar cell module (10) according to an embodiment of the present disclosure is a solar cell module having a plurality of solar cells (11) placed in a matrix form. The plurality of solar cells (11) include a first solar cell (11A) over at least one of a light receiving surface or a back surface of which an electrode having copper as a primary composition is formed, and a second solar cell (11B) over at least one of a light receiving surface or a back surface of which only an electrode having silver or aluminum as a primary composition is formed. At least one of the solar cells (11) placed at an outer periphery in a plan view of the solar cell module (10) is the second solar cell (11B).

## Description

### TECHNICAL FIELD

The present disclosure relates to a solar cell module and a solar cell array.

### BACKGROUND

A solar cell module includes a string of solar cells which is formed by connecting, with a wiring member, a plurality of solar cells having electrodes formed thereon, two protective members sandwiching the string, and sealing layers provided between the protective members and which seal each solar cell. JP 2013-033819 A discloses a solar cell module in which solar cells in which copper or silver is used for the electrodes are placed in a matrix form.

Because copper is inexpensive in comparison to silver, the manufacturing cost can be reduced by using metal having copper as a primary composition for the electrodes of the solar cell. However, when metal having copper as the primary composition is used for the electrodes, a problem called copper contamination may occur, in which copper ions diffuse into the sealing layer, promoting oxidative degradation of a resin. Thus, it is difficult to reduce the manufacturing cost while suppressing degradation of the resin due to copper contamination.

### SUMMARY

According to one aspect of the present disclosure, there is provided a solar cell module including a plurality of solar cells placed in a matrix form, wherein the plurality of solar cells include a first solar cell over at least one of a light receiving surface or a back surface of which an electrode having copper as a primary composition is formed, and a second solar cell over at least one of a light receiving surface or a back surface of which only an electrode having silver or aluminum as a primary composition is formed, and at least one of the solar cells placed at an outermost periphery in a plan view of the solar cell module is the second solar cell.

According to a solar cell module of an aspect of the present disclosure, the manufacturing cost can be reduced while suppressing degradation of the resin due to copper contamination.

### BRIEF DESCRIPTION OF DRAWINGS

The figures depict one or more implementations in accordance with the present teachings, by way of example only, not by way of limitations. In the figures, like reference numerals refer to the same or similar elements. Embodiments of the present disclosure will be described based on the following figures, wherein:
FIG. 1 is a plan view of a solar cell module according to an embodiment of the present disclosure, on a light receiving surface side.
FIG. 2 is a diagram showing a part of a cross section along a line AA in FIG. 1.
FIG. 3 is a plan view of a first solar cell and a second solar cell, on a light receiving surface side.
FIG. 4 is a diagram showing a cross section along a line AA in FIG. 3.
FIG. 5 is a plan view of the solar cell module according to the embodiment of the present disclosure, on the light receiving surface side, schematically showing placement of the solar cells.
FIG. 6 is a plan view of a solar cell module according to another configuration of the embodiment of the present disclosure, on a light receiving surface side, schematically showing placement of the solar cells.
FIG. 7A is a diagram showing an outer appearance of a light receiving surface of a solar cell module according to another configuration of the embodiment of the present disclosure, viewed from the front.
FIG. 7B is a diagram showing an outer appearance of the light receiving surface of the solar cell module according to the other configuration of the embodiment of the present disclosure, viewed from a slanted direction.
FIG. 8 is a plan view of a solar cell module according to another configuration of the embodiment of the present disclosure, on a light receiving surface side, schematically showing placement of the solar cells.

### DESCRIPTION OF EMBODIMENTS

A solar cell module according to an embodiment of the present disclosure will now be described in detail with reference to the drawings. The drawings referred to in the embodiment are schematically described, and a size ratio of constituent elements drawn in the figures or the like should be determined in consideration of the following description.

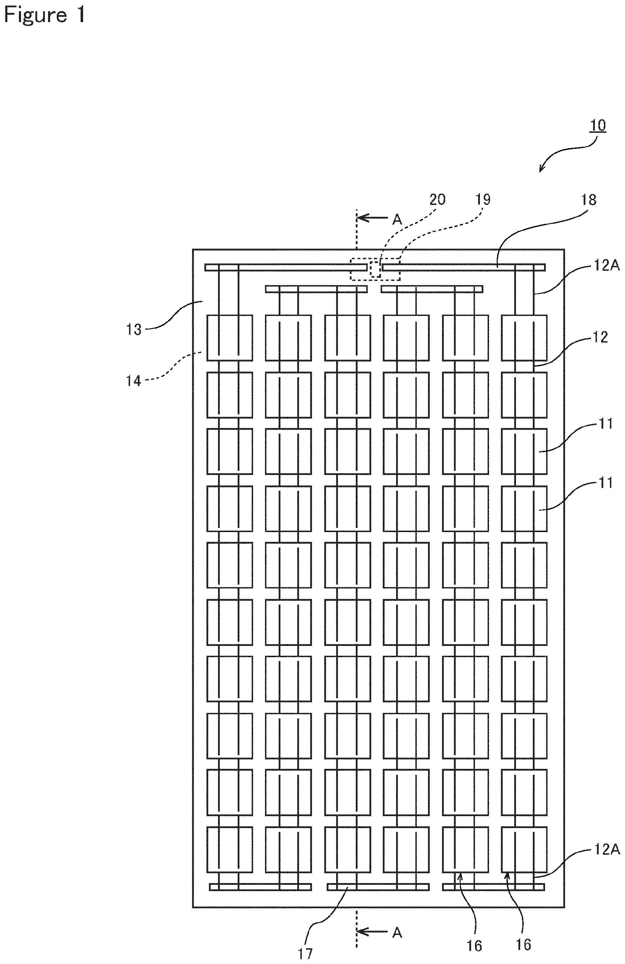

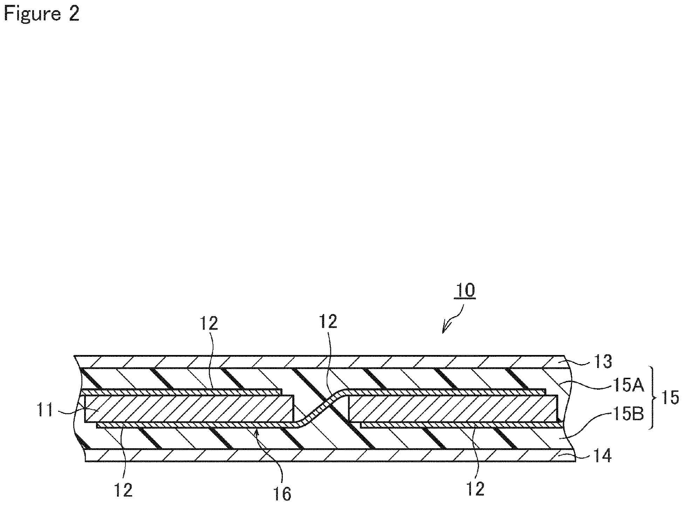

FIG. 1 is a plan view of a solar cell module 10 according to an embodiment of the present disclosure, on a light receiving surface side, and FIG. 2 is a diagram showing a part of a cross section along a line AA in FIG. 1. As shown in FIGs. 1 and 2, the solar cell module 10 includes a plurality of solar cells 11, a wiring member 12 connecting adjacent solar cells 11, a first protective member 13, and a second protective member 14. The first protective member 13 is provided on a side of a light receiving surface of the solar cell 11, and is a member which protects the light receiving surface side of the solar cell 11. The second protective member 14 is provided on a side of a back surface of the solar cell 11, and is a member which protects the back surface side of the solar cell 11. In addition, the solar cell module 10 includes a sealing layer 15 which is provided between the first protective member 13 and the second protective layer 14, and which seals the solar cell 11.

The "light receiving surface" of the solar cell 11 means a surface on which the light is primarily incident, and the "back surface" means a surface on an opposite side of the light receiving surface. Of the light incident on the solar cell 11, more than 50% of the light, for example, greater than or equal to 80% or greater than or equal to 90% of the light is incident from the light receiving surface side.

The solar cells 11 are placed in a matrix form with a gap therebetween, and are photovoltaic cells which generate electric power with illumination of light. As will be described later in detail, the solar cells 11 include a first solar cell 11A which uses an electrode having copper as a primary composition, and a second solar cell 11B which uses only an electrode having silver or aluminum as a primary composition. In the following, simple description of a "solar cell 11" refers to both the first solar cell 11A and the second solar cell 11B.

The wiring member 12 is, for example, a line member having a cross section in a radial direction of an approximate true circle shape, and is formed with metal such as copper (Cu), aluminum (Al), or the like as a primary composition. The wiring member 12 may include a plating layer having, as a primary composition, silver (Ag), nickel (Ni), or a low melting point metal used as solder. A diameter of the wiring member 12 is, for example, greater than or equal to 0.2 mm and less than or equal to 0.4 mm. Desirably, a plurality of the wiring members 12 are attached to the light receiving surface and the back surface of the solar cell 11. In FIG. 1, 2 wiring members 12 are provided, but the number of the wiring members 12 is not limited to this number, and may be, for example, greater than or equal to 4 and less than or equal to 20. Further, the cross-sectional shape of the wiring member 12 is not limited to the approximate true circle shape, and may alternatively be an approximate rectangular shape. When the cross-sectional shape of the wiring member 12 is the approximate rectangular shape, a thickness of the wiring member 12 is, for example, greater than or equal to 0.2 mm and less than or equal to 0.3 mm, and a width of the wiring member 12 is, for example, greater than or equal to 0.6 mm and less than or equal to 2.0 mm.

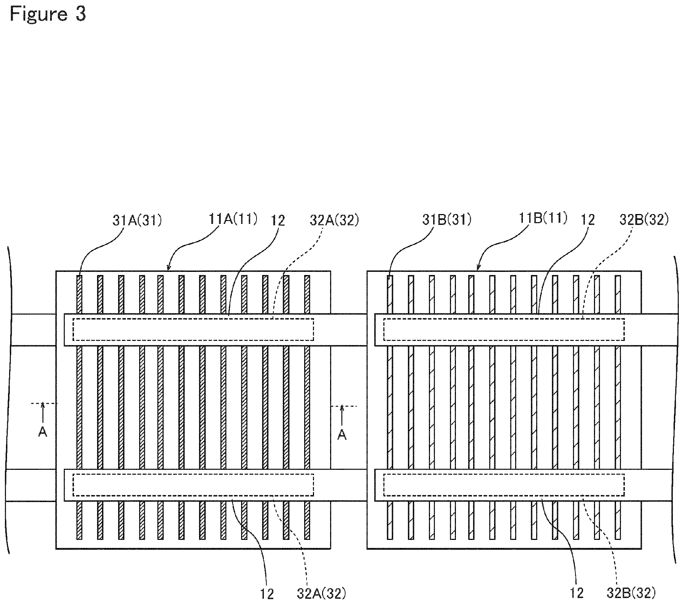

The wiring member 12 is placed along a longitudinal direction of a string 16, and is provided from a one-side end of one solar cell 11 among adjacent solar cells 11 to the other-side end of the other solar cell 11. A length of the wiring member 12 is slightly shorter than a length obtained by adding the lengths of two solar cells 11 and an inter-cell distance. The wiring member 12 is bent in a thickness direction of the module between adjacent solar cells 11, and is joined to the light receiving surface of the one solar cell 11 and the back surface of the other solar cell 11, respectively, using a resin adhesive or solder. The wiring member 12 is electrically connected to a bus bar electrode 32 of the solar cell 11 (refer to FIG. 3).

The solar cell module 10 desirably includes a plurality of strings 16 in which a plurality of solar cells 11 are arranged in a line. On respective sides in a longitudinal direction of each string 16, bridging wires 17 and 18 are provided at positions which do not overlap the solar cell 11. The bridging wire 17 is a wiring member connecting the strings 16. The bridging wire 18 is a wiring member connecting the string 16 and an output wiring (not shown). To the bridging wires 17 and 18, a wiring member 12A joined to a solar cell 11 positioned at an end of the string 16 is connected.

For the first protective member 13, for example, a glass substrate, a resin substrate, or the like which has a light transmissive property is employed. The first protective member 13 is in general flat, but may alternatively be curved. For the second protective member 14, a glass substrate, a resin substrate, or the like which has a light transmissive property may be employed similar to the first protective member 13, or a non-transparent member may be employed. For the second protective member 14, for example, a resin sheet having a thinner thickness than the first protective member 13 may be employed.

The resin substrate applied for the first protective member 13 and the second protective member 14 is formed from, for example, at least one material selected from polyethylene (PE), polypropylene (PP), cyclic polyolefin, polycarbonate (PC), polymethylmethacrylate (PMMA), polytetrafluoroethylene (PTFE), polystyrene (PS), polyethylene terephthalate (PET), and polyethylene naphthalate (PEN). In addition, from the viewpoint of further suppressing penetration of oxygen into the solar cell module 1, the first protective member 13 and the second protective member 14 may include a barrier layer formed from a metal layer or an oxide layer.

On the second protective member 14, an opening 20 is formed, for connecting the output wiring connected to the bridging wire 18 to a bypass diode housed in a terminal box 19. The terminal box 19 is adhered using an adhesive such as silicone, from the back surface side of the second protective member 14 and in a manner to cover the opening 20. In the present embodiment, as shown in FIG. 1, the opening 20 is formed in a region sandwiched by the bridging wire 18. No particular limitation is imposed on a shape of the terminal box 19, and the terminal box 19 has, for example, a rectangular parallelepiped shape.

Here, oxygen permeability of the first protective member 13 and the second protective member 14 is desirably less than or equal to 0.01 cc/m²/day, and is more desirably less than or equal to 0.005 cc/m²/day. In this case, the intrusion of oxygen into the solar cell module 10 can be suppressed. As a result, even when metal having copper as the primary composition is used for the electrode of the solar cell 11, degradation of the resin due to copper contamination can be further suppressed.

The sealing layer 15 is a resin layer which is provided between the first protective member 13 and the second protective layer 14, and which seals each solar cell 11. The sealing layer 15 closely contacts the solar cell 11 to restrict movement of the cell, and seals the solar cell 11 so that the solar cell 11 is not exposed to oxygen, water vapor, or the like. In the configuration exemplified in FIG. 2, the sealing layer 15 directly contacts each of the protective members and each of the solar cells 11. The solar cell module 10 has a layered structure in which the first protective member 13, the sealing layer 15, the string 16 of the solar cells 11, the sealing layer 15, and the second protective member 14 are layered in this order from the side of the light receiving surface. In the present embodiment, all of the solar cells 11 are sealed by the sealing layer 15, but alternatively, a structure may be employed in which, for example, a part of at least one solar cell 11 extends beyond the sealing layer 15. The sealing layer 15 is formed from a resin material such as, for example, polyolefin such as polyethylene or polypropylene, polyvinyl butyral (PVB), polyimide, polyethylene terephthalate (PET), or the like. Of these, the use of an olefin-based resin (in particular, a polymer including ethylene) is desirable.

The sealing layer 15 is formed from a first sealing layer 15A provided between the first protective member 13 and the solar cell 11, and a second sealing layer 15B provided between the second protective member 14 and the solar cell 11. The sealing layer 15 is desirably formed through a laminating process, using a resin member forming the first sealing layer 15A, and a resin member forming the second sealing layer 15B. For the first sealing layer 15A and the second sealing layer 15B, the same resin member may be employed, or different resin members may be employed. When the compositions of the resin members are the same, it may not be possible to recognize the interface between the sealing layers.

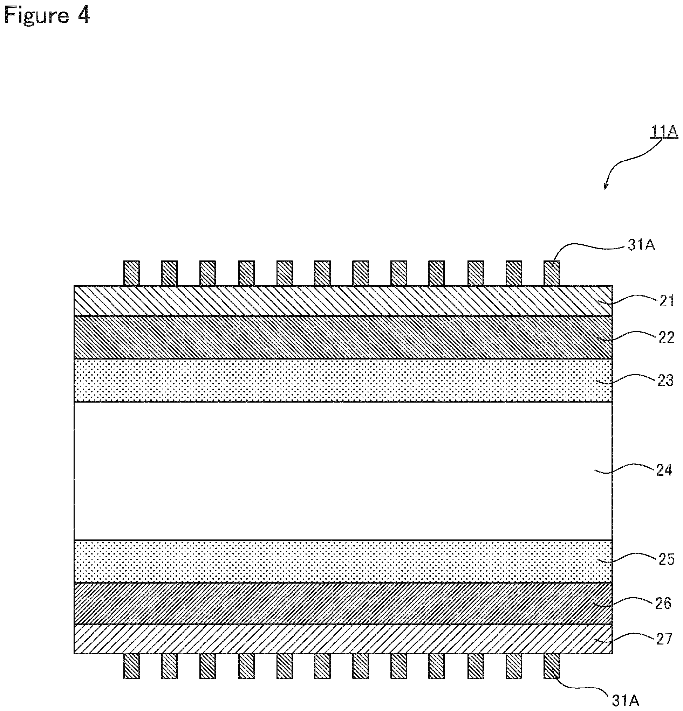

The solar cell 11 will now be described in detail with reference to FIGs. 3 and 4. FIG. 3 is a plan view of the first solar cell 11A and the second solar cell 11B, on the light receiving surface side, and FIG. 4 is a cross-sectional diagram along a line AA in FIG. 3.

As shown in FIG. 3, on each of the light receiving surface side and the back surface side of the solar cell 11, a plurality of finger electrodes 31 and two bus bar electrode 32 are formed. Here, the two bus bar electrode 32 on the light receiving surface side and the two bus bar electrodes on the back surface side are respectively lined up with each other along a layering direction of the solar cell 11. Here, "lined up with each other along a layering direction" means a state in which longitudinal directions of the bus bar electrodes 32 are overlapped in the plan view of the solar cell 11.

The finger electrode 31 includes a finger electrode 31A formed on each of the light receiving surface side and the back surface side of the first solar cell 11A, and a finger electrode 31B formed on each of the light receiving surface side and the back surface side of the second solar cell 11B. The finger electrode 31 is an electrode provided to collect and extract electricity generated by the solar cell 11. The finger electrode 31 is desirably placed such that current is collected evenly in the plane of the solar cell 11. For example, as shown in FIG. 3, the finger electrodes 31 are placed parallel with each other. The finger electrode 31 is placed over transparent conductive films 21 and 27 (refer to FIG. 4), in a manner to intersect and be electrically connected to the bus bar electrode 32.

Here, the finger electrode 31A of the first solar cell 11A is formed from metal having copper as the primary composition. "Having copper as the primary component" means that, of the elements forming the finger electrode 31A, copper is the element with the highest atomic ratio. By forming the finger electrode 31A with metal having copper as the primary composition, the amount of silver, which is expensive, that is used can be reduced, and the manufacturing cost can thus be reduced. The finger electrode 31A may be formed using a conductive paste having copper as the primary composition, but is desirably formed through plating including electroplating. In addition, the finger electrode 31A may include a corrosion-resistant layer such as tin (Sn) on a front-most surface, in order to improve the corrosion resistivity.

Alternatively, the material forming the finger electrode 31A may be changed for each of the first solar cells 11A. For example, the first solar cells 11A may include a solar cell which uses metal having an atomic ratio of copper of 90% for the finger electrode 31A, and another solar cell which uses metal having an atomic ratio of copper of 60% for the finger electrode 31A. Alternatively, for example, the first solar cells 11A may include a solar cell having a plating layer in the finger electrode 31A and another solar cell having no plating layer in the finger electrode 31A.

The finger electrode 31B of the second solar cell 11B is formed solely from metal having silver or aluminum as the primary composition. "Having silver or aluminum as the primary composition" means that, of the elements forming the finger electrode 31B, silver or aluminum is the element with the highest atomic ratio. As will be described later in detail, the second solar cell 11B is placed at an outermost periphery in the plan view of the solar cell module 10. Because of this, the degradation of the resin due to copper contamination can be suppressed by using only the metal having silver or aluminum as the primary composition for the finger electrode 31B of the second solar cell 11B. In the present embodiment, the second solar cell 11B is formed from metal having silver as the primary composition. The finger electrode 31B may be formed, for example, using a conductive paste having silver as the primary composition.

Line widths of the finger electrodes 31A and 31B are suitably determined according to a size of a current to be collected, thicknesses of the finger electrodes 31A and 31B, or the like, and are, for example, greater than or equal to 20 µm and less than or equal to 50 µm. Pitches of the finger electrodes 31A and 31B are, for example, greater than or equal to 0.5 mm and less than or equal to 2.2 mm. Further, the line width of the finger electrode 31A and the line width of the finger electrode 31B may be equal to or different from each other. The line width of the finger electrode 31 formed on the light receiving surface side and the line width of the finger electrode 31 formed on the back surface side may be equal to or different from each other.

The bus bar electrodes 32 include a bus bar electrode 32A formed on each of the light receiving surface side and the back surface side of the first solar cell 11A, and a bus bar electrode 32B formed on each of the light receiving surface side and the back surface side of the second solar cell 11B. The bus bar electrode 32 is an electrode provided for extracting the electricity generated by the solar cell 11. The bus bar electrode 32 is desirably positioned to collect the electricity, collected by the finger electrode 31, as uniformly as possible. In the present embodiment, as described above, two bus bar electrodes 32 are formed on each of the light receiving surface side and the back surface side of the solar cell 11. The bus bar electrode 32 may be omitted from the solar cell 1 so long as the configuration does not obstruct the collecting of the current.

As a material of the bus bar electrode 32A of the first solar cell 11A, a material that is different from that of the finger electrode 31A may be used, but the bus bar electrode 32A is desirably formed from metal having copper as the primary composition. In this case, the advantage of the present disclosure can be made more significant. A material of the bus bar electrode 32B of the second solar cell 11B is formed from metal having silver or aluminum as the primary composition. In addition, the bus bar electrodes 32A and 32B may be formed through a method similar to that for the finger electrodes 31A and 31B.

Widths of the bus bar electrodes 32A and 32B are suitably determined according to a size of the current to be collected, thicknesses of the bus bar electrodes 32A and 32B, or the like, and are, for example, greater than or equal to 40 µm and less than or equal to 100 µm. The line width of the bus bar electrode 32A and the line width of the bus bar electrode 32B may be equal to or different from each other. Moreover, the line widths of the bus bar electrodes 32A and 32B are set wider than the line widths of the finger electrodes 31A and 31B.

As shown in FIG. 4, in the solar cell 11, the transparent conductive film 21, a p-type amorphous silicon film 22, an i-type amorphous silicon film 23, an n-type monocrystalline silicon substrate 24, an i-type amorphous silicon film 25, an n-type amorphous silicon film 26, and the transparent conductive film 27 are layered, from the light receiving surface side. In FIG. 4, a cross section of the first solar cell 11A is shown, and the first solar cell 11A and the second solar cell 11B have the same cross-sectional structure except for the finger electrode 31 and the bus bar electrode 32 (refer to FIG. 3).

The n-type monocrystalline silicon substrate 24 receives light incident from the light receiving surface, and generates carriers. In the present embodiment, the n-type monocrystalline silicon substrate 24 is employed, but the present disclosure is not limited to such a configuration, and, alternatively, a crystalline semiconductor substrate of an n-type conductivity or a p-type conductivity may be employed. As an alternative to the monocrystalline silicon substrate, for example, there may be employed a polycrystalline silicon substrate, a gallium arsenide substrate (GaAs), an indium phosphide substrate (InP), or the like.

The i-type amorphous silicon film 23 is an amorphous silicon film layered and formed over the light receiving surface of the n-type monocrystalline silicon substrate 24. The p-type amorphous silicon film 22 is an amorphous silicon film layered and formed over the i-type amorphous silicon film 23, and doped with a p-type impurity.

The transparent conductive film 21 is layered and formed over the p-type amorphous silicon film 22. The transparent conductive film 21 is formed, for example, including at least one of metal oxides such as indium oxide (In₂O₂), zinc oxide (ZnO), tin oxide (SnO₂), and titanium oxide (TiO₂). Here, a configuration will be described in which the transparent conductive film 21 is formed using indium tin oxide (ITO).

The i-type amorphous silicon film 25 is an amorphous silicon film layered and formed over the back surface of the n-type monocrystalline silicon substrate 24. The n-type amorphous silicon film 26 is an amorphous silicon film layered and formed over the i-type amorphous silicon film 25, and doped with an n-type impurity.

The transparent conductive film 27 is layered and formed over the n-type amorphous silicon film 26. The transparent conductive film 27 is formed including a material similar to that of the transparent conductive film 21. Here, a configuration will be described in which the transparent conductive film 27 is formed using indium tin oxide (ITO).

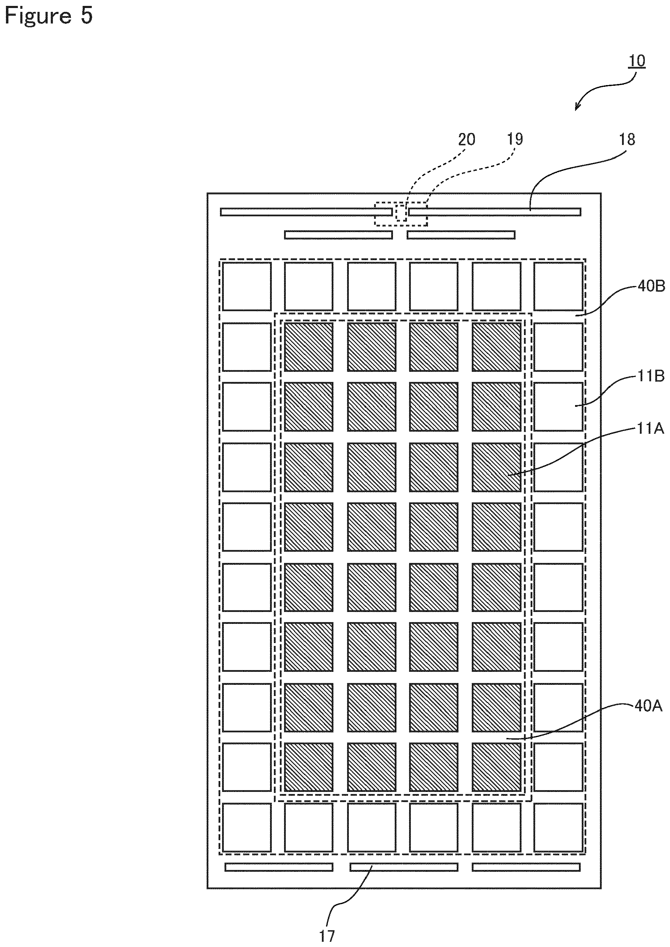

Placement of the first solar cell 11A and the second solar cell 11B in the solar cell module 10 according to the embodiment of the present disclosure will now be described with reference to FIG. 5. FIG. 5 is a plan view of the solar cell module 10 according to the embodiment of the present disclosure, on the light receiving surface side, and schematically shows the placement of the first solar cell 11A and the second solar cell 11B. FIG. 5 is shown in correspondence to FIG. 1, and illustration of the wiring member 12 is omitted from FIG. 5. In addition, the first solar cell 11A which uses the electrode having copper as the primary composition is shown with hatching, and the second solar cell 11B which uses only the electrode having silver or aluminum as the primary composition is shown without the hatching.

As shown in FIG. 5, in the plan view of the solar cell module 10, the first solar cells 11A and the second solar cells 11B are placed in a matrix form, and at least one second solar cell 11B is placed at an outermost periphery of the cell matrix. The solar cells placed at the outermost periphery tend to be easily affected by oxygen or the like intruding from outside of the solar cell module 10. Thus, by placing the second solar cell 11B at the outermost periphery, the degradation of the resin due to copper contamination can be suppressed. In the present embodiment, all of the solar cells placed at the outermost periphery are the second solar cells 11B.

In the present embodiment, all of the solar cells located at the directly inner side of the outermost solar cells are the first solar cells 11A, but the solar cell at this position may alternatively be the second solar cell 11B. By increasing the number of the second solar cells 11B, although the advantage of reducing the manufacturing cost is lessened, the degradation of the resin due to copper contamination can be further suppressed. In addition, from the viewpoint of suppressing the degradation of the resin due to copper contamination, desirably, the second solar cells 11B are placed at positions less than 8 cm from the outermost periphery of the solar cell module 10. In other words, desirably, the first solar cells 11A are placed at positions distanced by greater than or equal to 8 cm from the outermost periphery of the solar cell module 10.

In the plan view of the solar cell module 10, a total areas of the first solar cells 11A is desirably larger than a total areas of the second solar cells 11B. In this case, the manufacturing cost can be further reduced. In the present embodiment, the first solar cell 11A and the second solar cell 11B have the same area per solar cell. Thus, the total areas of the first solar cells 11A being larger than the total areas of the second solar cells 11B means that the number of the first solar cells 11A is larger than the number of the second solar cells 11B.

In addition, in the present embodiment, the finger electrode 31A is formed from the same material in all of the first solar cells 11A, but alternatively, the material forming the finger electrode 31A may be varied within the plane of the solar cell module 10. For example, a ratio of copper for the finger electrode 31A of the first solar cell 11A positioned at the center side of the solar cell module 10 may be set higher than a ratio of copper for the finger electrode 31A of the first solar cell 11A placed at an outer peripheral side of the solar cell module 10. The solar cell placed at the center side of the solar cell module 10 tends to not be affected by oxygen or the like intruding from the outside of the solar cell module 10. Thus, by setting the ratio of copper for the finger electrode 31A of the first solar cell 11A placed at the center side to be higher, the manufacturing cost can be further reduced while suppressing degradation of the resin due to copper contamination.

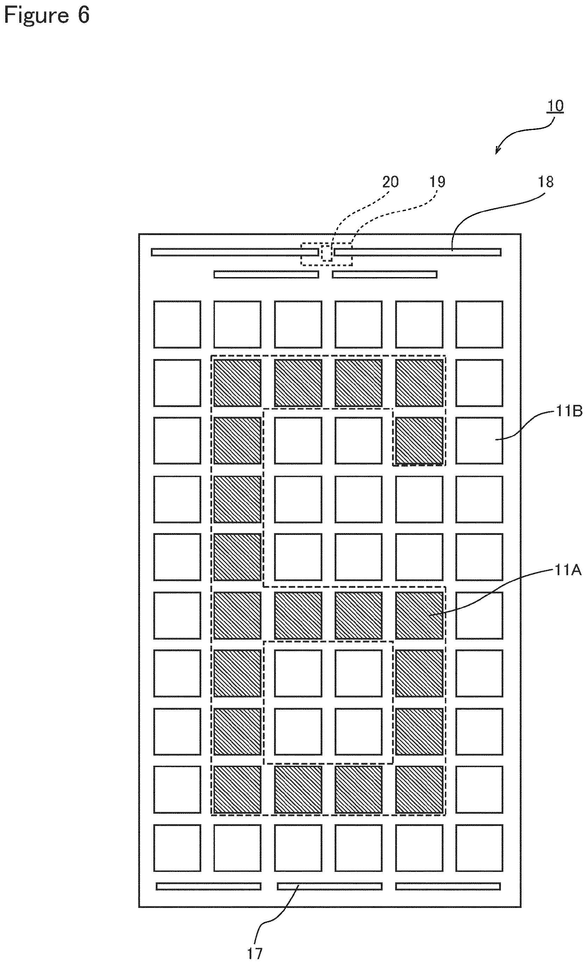

A region in which the first solar cells 11A are placed will hereinafter be called a first region 40A, and a region in which the second solar cells 11B are placed will hereinafter be called a second region 40B. In this case, the first region 40A has an outer appearance primarily with a color tone of copper, and the second region 40B has an outer appearance primarily with a color tone of silver. Thus, by placing the first solar cells 11A or the second solar cells 11B such that the first region 40A or the second region 40B has any of shapes of a straight line shape, a cross shape, a circular shape, a polygonal shape, or a particular text character, it is possible to improve the design of the solar cell module 10. In the example configuration shown in FIG. 5, the first region 40A has a rectangular shape. In an example configuration shown in FIG. 6, the first region 40A has a shape of a number "6".

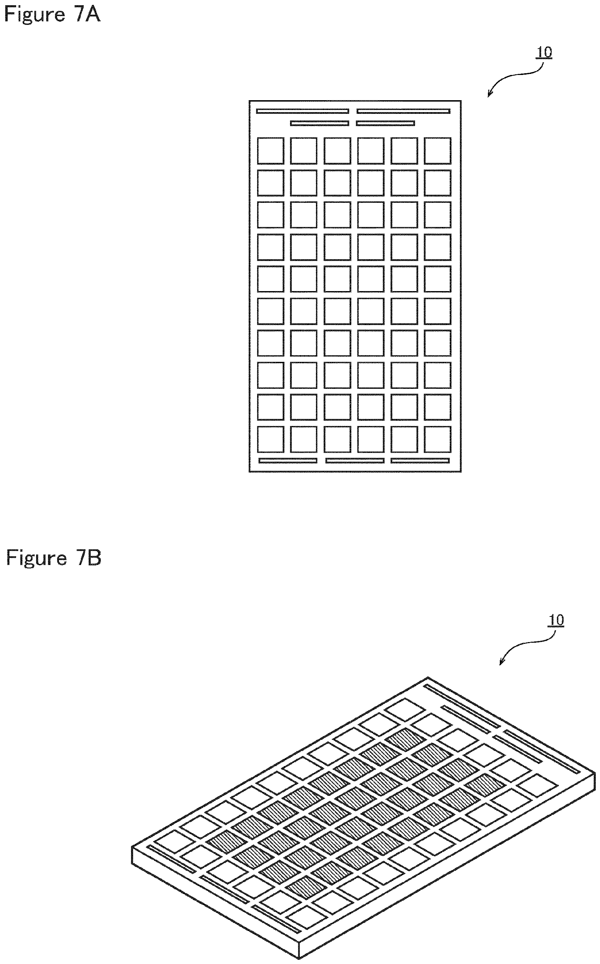

FIGs. 7A and 7B are schematic diagrams of the outer appearance of the solar cell module 10 when a Sn layer is formed as a corrosion-resistive layer over the surface of the finger electrode 31A of the first solar cell 11A. FIG. 7A shows the outer appearance of the solar cell module 10 when viewed from the front, and FIG. 7B shows the outer appearance of the solar cell module 10 when viewed from a predetermined angle. As shown in FIGs. 7A and 7B, by forming the Sn layer over the surface of the finger electrode 31A of the first solar cell 11A, it is possible to change the appearance between the time when the solar cell module 10 is viewed from the front and the time when the solar cell module 10 is viewed from the predetermined angle. More specifically, when the solar cell module 10 is viewed from the front, the Sn layer formed over the surface of the finger electrode 31A is viewed, the first region 40A has an outer appearance primarily with a color tone of Sn, and thus has an outer appearance with a color tone close to that of silver or aluminum of the second solar cell 11B. On the other hand, when the solar cell module 10 is viewed from a slanted direction, there is an angle at which the metal layer having copper as the primary composition below the Sn layer is viewed, and the first region 40A has an outer appearance primarily with the color tone of copper, which is reddish. In FIGs. 7A and 7B, the color tones of the second solar cells 11B and the Sn layers of the first solar cells 11A are shown without hatching, and the color tome of copper is shown with the hatching.

Alternatively, a solar cell array may be constructed in which a plurality of solar cell modules 10 having different shapes for the first regions 40A or the second regions 40B are arranged and placed, to display a particular figure, picture, text string, or the like as a whole. The solar cell array may include a solar cell module 1 in which only the second solar cells 11B are placed in a matrix form.

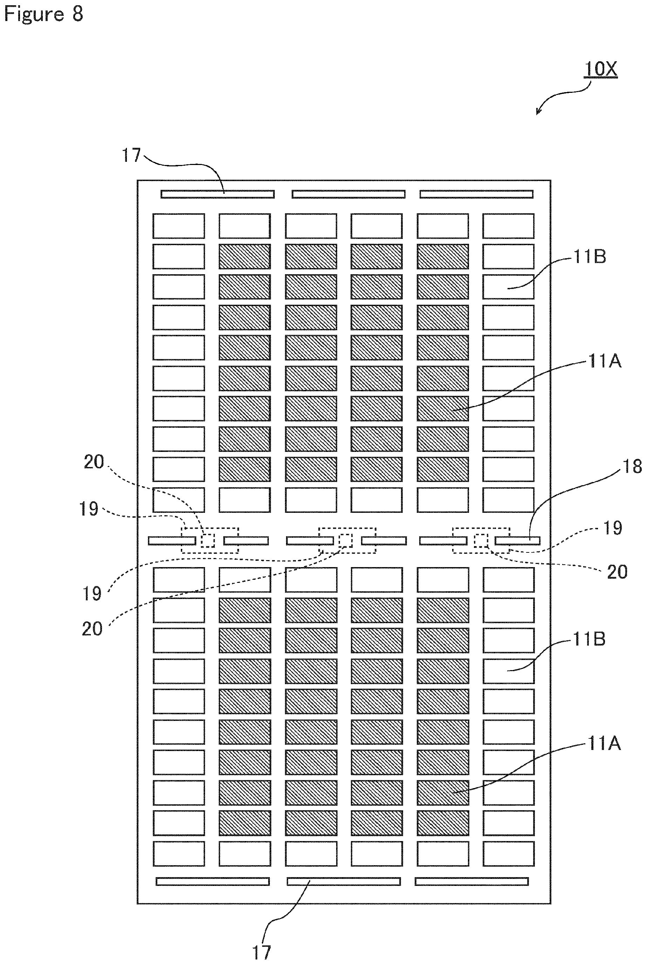

Placement of the first solar cells 11A and the second solar cells 11B in a solar cell module 10X according to another configuration of the embodiment of the present disclosure will now be described in detail with reference to FIG. 8. FIG. 8 is a plan view of the solar cell module 10X according to another configuration of the embodiment of the present disclosure, on the light receiving surface side, and schematically shows the placement of the first solar cells 11A and the second solar cells 11B. Similar to FIG. 5, illustration of the wiring member 12 is omitted from FIG. 8. In addition, in FIG. 8, the first solar cell 11A which uses the electrode having copper as the primary composition is shown with hatching, and the second solar cell 11B which uses only the electrode having silver or aluminum as the primary composition is shown without the hatching.

As shown in FIG. 8, the solar cell module 10X differs from the solar cell module 10 in that the solar cell module 10X has three terminal boxes 19, and the terminal boxes 19 are placed near the center part of the solar cell module 10X.

In the plan view of the solar cell module 10X, the second solar cells 11B are placed, in addition to the outermost periphery of the solar cell module 10X, in the center region of the solar cell module 10X. More specifically, in the plan view of the solar cell module 10X, the second solar cells 11B are placed to surround the opening 20 formed in the second protective member 14. With this configuration, even when oxygen or the like enters the inside of the solar cell module 10X from the outside through the opening 20, the degradation of the resin due to copper contamination can be suppressed.

Further, the second solar cell 11B is desirably placed at positions less than 8 cm from an outer edge of the opening 20 in the plan view of the solar cell module 10X. With this configuration, the degradation of the resin due to copper contamination can be further suppressed. In other words, the first solar cells 11A are desirably placed at positions distanced from the outer edge of the opening 20 by greater than or equal to 8 cm.

The present disclosure is not limited to the embodiment described above, and various modifications and improvements are possible within the scope and spirit of the present disclosure described in the claims.

In the above-described embodiment, the solar cells 11 are electrically connected to each other with the wiring member 12, but the present disclosure is not limited to this configuration. For example, the adjacent solar cells 11 may be electrically connected to each other by ends of the solar cells 11 being overlapped in the thickness direction of the solar cells 11 with a conductive or non-conductive adhesive or the like therebetween.

In addition, in the above-described embodiment, on the back surface side of the solar cell 11, the finger electrode 31 similar to that on the light receiving surface side is formed, but the present disclosure is not limited to this configuration. For example, an electrode covering approximately the entire region of the back surface side may be formed on the back surface side of the solar cell 11. For this electrode, aluminum or the like may be used, and, in the case of the first solar cell 11A, a copper thin film may be used for this electrode.

Moreover, in the above-described embodiment, the solar cell 11 is of a heterojunction type, but the present disclosure is not limited to this configuration. For example, the solar cell 11 may be of TOPCON type (Tunnel Oxide Passivated Contact cell), PERC type (Passivated Emitter and Rear Cell), or IBC type (Interdigitated Back Contact). Even when the solar cell 11 has these structures, the advantages of the present disclosure can be realized by producing the first solar cell 11A having the electrode having copper as the primary composition formed thereon and the second solar cell 11B having only the electrode having silver or aluminum as the primary composition formed thereon, and placing these solar cells in predetermined positions.

While the foregoing has described what are considered to be the best mode and/or other examples, it is understood that various modifications may be made therein, and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A solar cell module (10) comprising:
a plurality of solar cells (11) placed in a matrix form, wherein
the plurality of solar cells (11) include:
a first solar cell (11A) over at least one of a light receiving surface or a back surface of which an electrode having copper as a primary composition is formed; and
a second solar cell (11B) over at least one of a light receiving surface or a back surface of which only an electrode having silver or aluminum as a primary composition is formed, and
at least one of the solar cells (11) placed at an outermost periphery in a plan view of the solar cell module (10) is the second solar cell (11B).

2. The solar cell module (10) according to claim 1, wherein
the solar cell (11) placed at the outermost periphery in the plan view of the solar cell module (10) is the second solar cell (11B).

3. The solar cell module (10) according to claim 1 or 2, wherein
the solar cell (11) placed at a position further inward than the solar cell (11) placed at the outermost periphery in the plan view of the solar cell module (10) is the first solar cell(11A).

4. The solar cell module (10) according to any one of claims 1 to 3, wherein
the solar cell (11) placed at a position distanced from the outermost periphery of the solar cell module (10) by greater than or equal to 8 cm in the plan view of the solar cell module (10) is the first solar cell (11A).

5. The solar cell module (10) according to any one of claims 1 to 4, wherein
a total areas of the first solar cells (11A) in the plan view of the solar cell module (10) is larger than a total areas of the second solar cells (11B).

6. The solar cell module (10) according to any one of claims 1 to 5, further comprising:
a first protective member (13) placed at a light receiving surface side of the solar cell module (10); and
a second protective member (14) placed at a back surface side of the solar cell module (10), wherein
oxygen permeability of each of the first protective member (13) and the second protective member (14) is less than or equal to 0.01 cc/m²/day.

7. The solar cell module (10) according to claim 6, wherein
an opening is formed at a part of the second protective member (14), and
the solar cell (11) which overlaps the opening or which surrounds the opening in the plan view of the solar cell module (10) is the second solar cell (11B).

8. The solar cell module (10) according to claim 7, wherein
the solar cell (11) placed at a position distanced from an outer edge of the opening by greater than or equal to 8 cm in the plan view of the solar cell module (10) is the first solar cell (11A).

9. The solar cell module (10) according to any one of claims 1 to 8, wherein
a region in which the first solar cells (11A) are placed or a region in which the second solar cells (11B) are placed has any of shapes of a straight line shape, a cross shape, a circular shape, a polygonal shape, or a particular text character in the plan view of the solar cell module (10).

10. The solar cell module (10) according to any one of claims 1 to 9, wherein
an appearance of the solar cell module (10) when the light receiving surface or the back surface of the solar cell module (10) is viewed from a predetermined angle differs from an appearance of the solar cell module (10) when the light receiving surface or the back surface of the solar cell module (10) is viewed from the front, and
a particular figure or text is displayed when the light receiving surface or the back surface of the solar cell module (10) is viewed from the predetermined angle.

11. A solar cell array comprising:
a plurality of solar cell modules (10), wherein
the plurality of solar cell modules (10) include at least one solar cell module (10) according to claim 9.
